## Europäisches Patentamt
## European Patent Office
## Office européen des brevets

(19)

(11) Veröffentlichungsnummer: **0 003 330**
**B1**

(12) **EUROPÄISCHE PATENTSCHRIFT**

(45) Veröffentlichungstag der Patentschrift: **09.06.82**

(21) Anmeldenummer: **79100154.8**

(22) Anmeldetag: **19.01.79**

(51) Int. Cl.³: **H 01 L 21/223,**
**H 01 L 21/70**

(54) Verfahren zum Herstellen von hochintegrierten Halbleiteranordnungen mit aneinandergrenzenden, hochdotierten Halbleiterzonen entgegengesetzten Leitungstyps.

(30) Priorität: **27.01.78 US 872982**

(43) Veröffentlichungstag der Anmeldung:
**08.08.79 Patentblatt 79/16**

(45) Bekanntmachung des Hinweises auf die Patenterteilung:
**09.06.82 Patentblatt 82/23**

(84) Benannte Vertragsstaaten:
**DE FR GB**

(56) Entgegenhaltungen:
**DE - A - 1 809 683**
**US - A - 3 713 908**
**US - A - 4 049 478**
**US - A - 3 928 091**

(73) Patentinhaber: **International Business Machines Corporation**
**Armonk, N.Y. 10504 (US)**

(72) Erfinder: **Bohg, Armin**
**Mozartstrasse 13**
**D-7031 Neuweiler (DE)**
Erfinder: **Magdo, Ingrid Emese**
**Carpenter Road**
**Hopewell Junction New York 12533 (US)**

(74) Vertreter: **Gaugel, Heinz, Dipl.-Ing.**
**Schönaicher Strasse 220**
**D-7030 Böblingen (DE)**

Courier Press, Leamington Spa, England.

## Verfahren zum Herstellen von hochintegrierten Halbleiteranordnungen mit aneinandergrenzenden, hochdotierten Halbleiterzonen entgegengesetzten Leitungstyps

Die Erfindung betrifft ein Verfahren zum Herstellen von hochintegrierten Halbleiteranordnungen mit aneinandergrenzenden, hochdotierten Halbleiterzonen entgegengesetzten Leitungstyps, wobei in Überlappungsbereichen der Halbleiterzonen Kristallfehler vermieden werden.

In der Halbleitertechnik wird durch Reduzierung der Größe der aktiven und passiven Halbleiterelemente in Verbindung mit der Reduzierung der vertikalen Dickenabmessung des Teiles der Halbleiterscheibe, in dem die aktiven und passiven Elemente untergebracht werden, eine verbesserte Leistungsfähigkeit der bei gleichzeitig verringerten Kosten hergestellten Halbleiteranordnungen erzielt. Die Kosten pro Halbleiteranordnung werden deswegen verringert, weil mit einer gegebenen Folge von Prozeßschritten eine beträchtlich höhere Anzahl von Halbleiterelementen bzw. Schaltungen auf einem einzelnen Halbleiterplättchen untergebracht werden kann. Die Gesamtkosten des Herstellungsverfahrens und des Materialaufwandes verteilen sich dann auf eine größere Anzahl von Anordungen. Durch die Reduzierung der Größe der Halbleiteranordnungen wird auch die Funktionstüchtigkeit erhöht, da parasitäre kapazitive und induktive Eigenschaften reduziert werden.

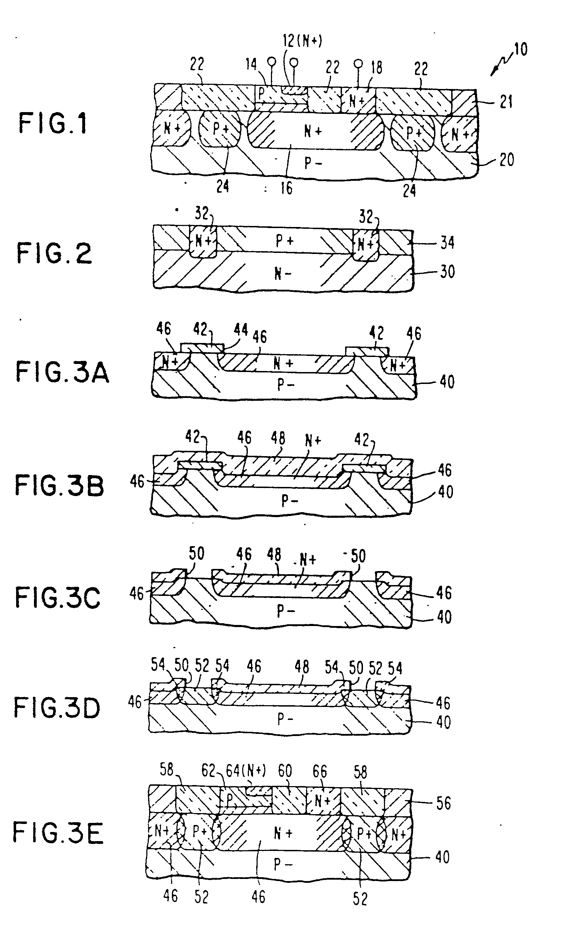

Mit der Erhöhung der Packungsdichte nimmt man in Kauf, daß immer häufiger Überlappungen von hochdotierten Halbleiterzonen entgegengesetzten Leitungstyps stattfinden. Ein Beispiel für eine hochintegrierte Halbleiteranordnung, bei der die Wahrscheinlichkeit der Überlappung von zwei hochdotierten Halbleiterzonen entgegengesetzten Leitungstyps sehr wahrscheinlich ist, ist in Fig. 1 dargestellt. Das Beispiel umfaßt einen Transistor 10, wie er in der DE—OS 22 18 892 beschrieben ist. Der Transistor weist ein Emitterzone 12, eine Basiszone 14, eine Subkollektorzone 16 und eine Kollektorkontaktierungszone 18 auf. Der Transistor ist von den auf dem gemeinsamen Halbleitersubstrat 20 benachbart angeordneten Elementen durch eine ringförmige Isolationszone aus abgesenktem Oxid 22 umgeben. Unterhalb dieser dielektrischen Isolationszone 22 ist eine hochdotierte Subisolationszone 24 angeordnet, die den Abstand innerhalb der Epitaxieschicht 21 zwischen dem Grund der Zone 22 und dem Substrat 20 überbrückt. Der PN-Übergang zwischen der Subkollektorzone 16 und dem Substrat 20 vervollständigt die elektrische Isolation des Transistors 10. Mit größerer Packungsdichte der Anordnungen vergrößert sich die Wahrscheinlichkeit, daß sich die Zonen 16 und 24 überlappen. Findet eine solche Überlappung der Zonen 16 und 24 entgegengesetzten Leitungstyps statt und sind diese Zonen außerdem hochdotiert, so kann mann beobachten, daß sich ausgehend von dem Überlappungsbereich Kristallfehler nach allen Seiten ausbreiten. Diese Kristallfehler verursachen Leckstromwege und/oder Kurzschlüsse zwischen den verschiedenen Halbleiterzonen des Transistors und auch zwischen dem Transistor und benachbarten Elementen auf dem Halbleitersubstrat 20.

Hier will die Erfindung Abhilfe schaffen. Die Erfindung, wie sie in den Ansprüchen gekennzeichnet ist, löst die Aufgabe, ein Verfahren zum Herstellen von hochintegrierten Halbleiteranordnungen mit aneinandergrenzenden, hochdotierten Halbleiterzonen entgegengesetzten Leitungstyps anzugeben, bei dem Kristallfehler vermieden werden, die in Überlappungsbereichen der beiden Halbleiterzonen auftreten und die Funktionstüchtigkeit der Halbleiteranordung zumindest beeinträchtigen können.

Die durch die Erfindung erreichten Vorteile sind im wesentlichen darin zu sehen, daß eine maximal mögliche Packungsdichte erzielt werden kann, da die angesprochenen Halbleiterzonen extrem dicht beieinander angeordnet werden können.

Im folgenden wird die Erfindung anhand der Zeichungen näher erläutert. Es ziegt:

Fig. 1 die Schnittansicht einer bekannten Halbleiteranordnung,

Fig. 2 die Schnittansicht einer nach dem erfindungsgemäßen Verfahren hergestellten Halbleiteranordnung, und

Fign. 3A bis 3E eine Folge von Schnittansichten einer weiteren nach dem erfindungsgemäßen Verfahren hergestellten Halbleiteranordung.

Wie bereits festgestellt, erzeugen hochdotierte Halbleiterzonen entgegengesetzten Leitungstyps in einem monokristallinen Halbleiterkörper dann kristallographische Fehler, wenn sie sich überlappen. Diese kristallographischen Fehler sind in der Halbleitertechnik von großer Wichtigkeit. Die angesprochenen Kristallfehler bewirken, daß in ihrem Bereich Störstellen sehr viel rascher diffundieren können, als in den fehlerfreien Halbleiterbereichen. Diese Diffusionen erfolgen während der normalen Herstellungsprozesse, bei denen Erhitzungen der Anordnung erforderlich sind. Diese Diffusionen treten aber auch noch bei der späteren Inbetriebnahme der Halbleiteranordungen auf, wenn auch nur in geringerem Maße. Die sich in diesen Fehlstellen ansammelnden Dotierungsstoffe erzeugen feinste leitende Kanäle. Diese leitenden Kanäle können Strom führen und dabei zu Kurzschlüssen führen, wenn sie sich zwischen zwei unterschiedlichen Halbleiterzonen erstrecken, also beispielsweise zwischen Emitter- und Kollektorzone. Die Kristallfehler können schadhafte Halbleiterübergänge verursachen, die zu einer Beeinträchtigung der Leistungsfähigkeit oder Functionstüchtigkeit eines Halbeiterelementes oder zu einer schadhaften Isolation führen. Im allgemeinen führen kristallographische Fehler in einer Halbleiteranordnung zu einer allmählichen Verschlechterung der Eigenschaften. Auch wenn eine kristallographische Fehler aufweisende Halbleiteranordnung nach der Herstellung die abschließende Prüfung besteht, so ist doch mit einer beträchtlichen Verringerung der erreichbaren Lebensdauer zu rechnen.

Man hat erkannt, daß in einem Kristallgitter mechanische Spannungen auftreten, wenn die kombinierte Dotierungskonzentration in Überlappungsbereichen von Halbleiterzonen entgegengesetzten Leitungstyps bestimmte kritische Grenzen überschreitet. Diese mechanischen Spannungen verursachen Gitterversetzungen. Man kann davon ausgehen, daß das Vorhandensein von Störstellen eines Leitungstyps in einer Halbleiterzone zu einer Erhöhung des Dotierungspegels von anschließend eingebrachten Dotierungsstoffen des entgegengesetzten Leitungstyps führt. Der Dotierungspegel des zweiten Dotierungsstoffes in Kombination mit dem ersten Dotierungspegel führt zu einer nicht zu vernachlässigenden Beanspruchung des Kristallgitters, wodurch sich die Kristallfehler ergeben. Außer den Kristallfehlern entwickeln sich feinste leitende Kanäle, Kurzschlüsse und Leckstromwege, die zu einer Verschlechterung der Eigenschaften der Anordung führen. Man hat beispielsweise beobachtet, daß bei einer BBr$_3$-Diffusion in eine Halbleiterzone mit vorausgegangener As-Diffusion einer Oberflächenkonzentration von $2 \times 10^{21}$ Atome/cm$^3$ die As-Diffusion die tatsächliche Dotierung des Siliciumkörpers mit Bor um nahezu das Vierfache erhöht und in den Überlappungsbereichen zu den beobachteten Kristallfehlern führt.

Die in Fig. 2 dargestellte Struktur kann unter Anwendung des erfindungsgemäßen Verfahrens hergestellt werden. Diese Struktur kann beispielsweise das Halbleitersubstrat umfassen, auf dem beispielsweise ein Transistor verwirklicht wird, wie er in Fig. 1 dargestellt ist. Beim Herstellen der Struktur gemäß Fig. 2 wird zunächst ein monokristallines Halbleiterplättchen 30 aus Silicium oxidiert. Dabei bildet sich auf der Oberfläche eine nicht dargestellte Siliciumdioxidschicht, die als Maskierungsschicht dient. In der Maskierungsschicht werden Maskenfenster für durchzuführende Diffusionen freigelegt. Im Bereich der Maskenfenster erfolgt eine Diffusion von Arsen. Bei dieser Diffusion entstehen die Isolationszonen 32, die von oben gesehen im allgemeinen ringförmig ausgebildet sind. Die Halbleiterzonen 32 haben eine maximale Dotierungskonzentration im Bereich von $5 \times 10^{20}$ bis $2 \times 10^{21}$ Atome/cm$^3$. Diese Konzentration kann durch ein Kaspeldiffusion erreicht werden. Dabei wird das Halbleiterplättchen in eine Diffusionskaspel aus Quarz gebracht, die als Diffusionsquellenmaterial Arsen enthält. Die Kapsel wird verschlossen und dann erhitzt. Die Dauer der Erhitzung ergibt sich aus der Tiefe, die die Störstellen erreichen sollen. Die Diffusionsquelle besteht aus pulverisiertem Silicium, das während einer bestimmten Zeit Arsen ausgesetzt wurde, um bei geeigneter Erhitzung Arsen bei dem gewünschten Dampfdruck abzugeben. Eine entsprechende Diffusionsquelle ist in der US-Patentschrift 3 658 606 beschrieben. Nach der Arsendiffusion, bei der die Halbleiterzone 32 entsteht, wird die Maskierungsschicht entfernt. Über die gesamte Oberfläche erfolgt anschließend eine Diffusion von Bor, bei der die Halbleiterzone 34 entsteht. Die maximale Oberflächenkonzentration in der Halbleiterzone 34 ist $5 \times 10^{19}$ bis $3 \times 10^{20}$ Atome/cm$^3$. Diese Borkonzentration erzielt man durch eine Kaspeldiffusion. Dabei wird das Halbleiterplättchen zusammen mit einer verdampfbaren Quelle aus Bor in eine Kaspel aus Quarz gebracht. Die Kaspel wird abgeschlossen und erhitzt. Die Erhitzungsdauer ergibt sich aus der angestrebten Tiefe der Diffusionsfront. Als Diffusionsquelle kann pulverisiertes Silicium verwendet werden, das verdampftem Bor das ausgesetzt wurde. Wie die Fig. 2 zeigt, überlappen sich die Halbleiterzonen 32 und 34, da die Halbleiterzone 34 durch eine ganzflächige Diffusion hergestellt wurde. Es hat sich nun gezeigt, daß in dem Überlappungsbereich keine Kristallfehler entstehen, wenn die Arsen- und Borkonzentration in den Halbleiterzonen innerhalb der erwähnten Grenzen gehalten wird. Werden jedoch diese Konzentrationen überschritten, so bilden sich die kristallographischen Fehler aus und führen zu der bereits beschriebenen Veschlechterung der fertigen Halbleiteranordnung. Wählt man für die Halbleiterzonen eine Dotierungskonzentration, die unterhalb der angegebenen unteren Grenzwerte liegt, so handelt es sich bereits nicht mehr um das, was man unter einer hochdotierten Halbleiterzone versteht. Nur schwach dotierte, überlappende Halbleiterzonen erzeugen keine Kristallfehler. Im Rahmen der Erfindung wurde festgestellt, daß die angegebenen Grenzwerte kritisch sind, wenn sich die Halbleiterzonen überlappen. Die Halbleiterzonen 32 und 34 könnten auch auf andere Weise, beispielsweise durch Ionenimplantation hergestellt werden, Wesentlich ist, daß die maximalen Konzentrationen der Halbleiterzonen in den Überlappungsbereichen die angegebenen Grenzwerte nicht überschreiten. Die Diffusion von Bor kann auch dadurch erfolgen, daß eine Mischung aus BBr$_3$, Sauerstoff und einem inerten Trägergas über das erhitzte Halbleiterplättchen geleitet wird. Dieses Diffusionsverfahren ist in der US-Patentschrift 3 676 231 beschrieben. Um aber die Borkonzentration innerhalb des angegebenen Bereiches zu halten, ist es erforderlich, daß das Halbleiterplättchen auf einer geringeren als der normalen Temperatur gehalten wird. Diese niedrigere Temperatur liegt im Bereich von 925 bis 970°C. Das Halbleiterplättchen wird während einer Dauer von etwa 10 Minuten bei dieser Temperatur der Mischung aus $BBr_3$, Sauerstoff und Argon ausgesetzt. Die sich dabei bildende borreiche, glasartige Schicht wird dann entfernt. Das sich bereits im Halbleiterplättchen befindende Bor wird bei einer Temperatur im Bereich von 1000 bis 1050°C und einer Dauer von etwa 100 Minuten in das Halbleiterplättchen eingetrieben. Wird die glasartige Schicht nicht vor dem Eintreibprozeß entfernt, so könnte die Borkonzentration die angegebenen Grenzwerte überschreiten. Die sich ergebende, in Fig. 2 dargestellte Struktur kann also Basis für eine integrierte Halbleiteranordnung verwendet werden, wie sie in Fig. 1 dargestellt ist. Dazu wird auf die Oberfläche der in Fig. 2 dargestellten Struktur eine Epitaxieschicht aufgewachsen, abgesenkte Isolationszonen aus Siliciumdioxid gebildet und in der Epitaxieschicht die Transistorstruktur vervollständigt. Die Transistorstruktur könnte auch mit einer Sperrschicht-Isolation anstelle der vorgesehenen dielektrischen Isolation ausgestattet werden. Dabei wäre über der Halbleiterzone 32 in die Epitaxieschicht eine entsprechende Halbleiterzone einzudiffundieren.

Anhand der Figuren 3A bis 3E wird nun ein weiteres bevorzugtes Ausführungsbeispiel des erfindungsgemäßen Verfahrens beschrieben. Wie es sich aus der Fig. 3A ergibt, wird die Oberfläche eines monokristallinen Halbleiterplättchens 40 aus Silicium oxidiert. Dabei bildet sich eine Siliciumdioxidschicht 42. In dieser Schicht 42 werden Maskenfenster 44 freigelegt. Im Bereich dieser Maskenfenster wird Arsen eindiffundiert. Es entsteht dabei eine hochdotierte Halbleiterzone 46, die als Subkollektorzone eines Transistors verwendbar ist. Die arsendotierte Zone 46 kann entweder durch eine Kapseldiffusion oder eine Arsenimplantation hergestellt werden. Auch hier muß die maximale Oberflächenkonzentration von Arsen in der Halbleiterzone 46 im Bereich von $5 \times 10^{20}$ bis $2 \times 10^{21}$ Atome/cm$^3$ liegen. Wie die Fig. 3B zeigt, wird die Oberfläche des Halbleiterplättchens 40 reoxidiert, wobei die Siliciumdioxidschicht 48 entsteht. In dieser Schicht werden, wie die Fig. 3C zeigt, Maskenfenster 50 freigelegt. Im Bereich dieser Maskenfenster erfolgt die Diffusion von Bor. Dabei bilden sich die Halbleiterzonen 52, wie es in Fig. 3D dargestellt ist. Die Halbleiterzonen 52 können wiederum entweder in einer Kaspeldiffusion, durch Ionenimplantation oder in einer offenen Diffusion von $BBr_3$, Sauerstoff und Argon mit im Anschluß an die Entfernung der glasartigen Schicht erfolgendem Eintreibschritt. Die drei unterschiedlichen Verfahren wurden bereits in Zusammenhang mit der Fig. 2 beschrieben. Wie der Fig. 3D zu entnehmen ist, überlappen sich die Halbleiterzonen 52 und 46 im Bereich 54. Werden die Bor- und Arsenkonzentrationen in den angegebenen Grenzen gehalten, so entstehen im Überlappungsbereich 54 keine Kristallfehler. Ein wesentlicher Vorteil des·

erfindungsgemäßen Verfahrens besteht darin, daß die Subisolationszonen und die Subkollektorzone mit geringeren Toleranzen in der Abmessung herstellbar sind und sogar überlappen dürfen, ohne daß Kristallfehler zu erwarten wären.

Fig. 3E zeigt eine fertige Transistorstruktur, ausgebildet auf einem Substrat 40 aus Silicium. Die in der Struktur gemäß Fig. 3D noch vorhandene Oxidschicht 48 wird entfernt. Anschließend wird ein Epitaxieschicht 56 aufgebracht. Die Oberfläche der Epitaxieschicht 56 wird oxidiert, wobei sich eine nicht dargestellte Siliciumdioxidschicht bildet. Auf diese Siliciumdioxidschicht wird eine Siliciumnitridschicht aufgebracht. Über den Halbleiterzonen 52 und der zu bildenden Kollektorkontaktierungszone werden Maskenöffnungen freigeleigt. Anschließend wird ein Teil des Siliciums entfernt. In einem Oxidationsschritt werden dann die abgesenkten Isolationszonen 58 aus Siliciumdioxid gebildet, die über den Isolationszonen 52 angeordnet sind und die Isolation des Transistors vervollständigen. Eine zusätzliche Isolationszone 60 trennt die Kollektorkontaktzone von der Basiszone und der Emitterzone des Transistors. Diese Prozeßschritte sind wiederum in der DE—OS 22 18 892 beschrieben. Die Basiszone 62 wird dann durch Diffusion oder Ionenimplantation hergestellt. Ebenfalls durch Diffusion oder Ionenimplantation wird schließlich die Emitterzone 64 und die Kollektorkontaktzone 66 gebildet. Es zeigt sich, daß offensichtlich zwischen den Isolationszonen 52 und der Subkollektorzone 46 sind keine besonderen Toleranzen zuzulassen, da diese Zonen überlappen dürfen.

Im folgenden werden spezielle Ausführungsbeispiele des erfindungsgemäßen Verfahrens angegeben.

Beispiel 1

Ein monokristallines Halbleiterplättchen aus Silicium mit einer Bordotierung von $8 \times 10^{14}$ Atome/cm$^3$ und einem spezifischen Widerstand von 10 $\Omega \cdot$ cm wird in eine eine Diffusionsquelle aus Arsen enthaltende Diffusionskapsel gebracht, die dann abgeschlossen wird. Die Diffusionsquelle besteht aus pulverisiertem Silicium, in das Arsen eindiffundiert wurde.

Die Diffusionkapsel wird auf eine Temperatur von 1105°C erhitzt und auf dieser Temperatur für eine Dauer von 110 Minuten gehalten. Die Kapsel wird anschließend geöffnet und das Halbleiterplättchen entnommen. Man stellt eine Oberflächenkonzentration des Arsens von $3 \times 10^{21}$ Atome/cm$^3$ fest, die Tiefe der eindiffundierten Zone beträgt 1,1 $\mu$m. Der spezifische Widerstand an der Oberfläche ergibt sich zu 6,1 $\Omega/\square$. Das Halbleiterplättchen wird dann in eine zweite, eine Diffusionquelle aus Bor enthaltende Diffusionkapsel gebracht, die ebenfalls abgeschlossen wird. Auch das hier verwendete Diffusionsquellenmaterial besteht aus pulverisiertem Silicium, in das Bor eindiffundiert wurde. Die Kapsel wird auf einer Temperatur von 1050°C während einer Dauer von 116 Minuten gehalten. Bei diesem Diffusionsprozeß erhält man eine Borkonzentration von $6,5 \times 10^{19}$ Atome/cm³ und eine Diffusionstiefe von 1,1 $\mu$ Der spezifische Widerstand beträgt 56 $\Omega/\square$. Die Borkonzentration und die Diffusionstiefe wurden dabei bei einem zusätzlich eingebrachten Halbleiterplättchen ermittelt. Da beide Diffusionen ganzflächig durchgeführt wurden, ergibt sich eine 100-prozentige Überlappung. Im Elektronenmikroskop läßt sich feststellen, daß keine Kristallfehler auftreten.

Beispiel 2

Ein monokristallines Halbleiterplättchen aus Silicium wird in eine eine Diffusionsquelle aus Arsen enthaltende Diffusionskapsel wie im Beispiel 1 gebracht. Die Diffusionskapsel wird während einer Dauer von 110 Minuten auf einer Temperatur von 1105°C gehalten. Anschließend wird das Halbleiterplättchen in eine offene Diffusionskammer gebracht, durch die eine Mischung von 1% $BBr_3$, 2% Sauerstoff und Argon als Trägergas während einer Dauer von 10 Minuten geleitet wird. Das Halbleiterplättchen wird dabei auf einer Temperatur von 950°C gehalten. Anschließend wird das Halbleiterplättchen entfernt und die gebildete borreiche, glasartige Schicht von der Oberfläche entfernt. Das Halbleiterplättchen wird erneut in die Diffusionskammer gebracht und während einer Dauer von 100 Minuten auf einer Temperatur von 1000°C gehalten. Während dieser Zeit wird Argon über die Oberfläche geleitet. Die erreichte Borkonzentration ergibt sich zu $6 \times 10^{19}$ Atome/cm³. Auch hier sind im Elektronenmikroskop trotz der 100-prozentigen Überlappung der beiden arsen- und bordotierten Zonen keine Kristallfehler festzustellen.

Beispiel 3

Ein monokristallines Halbleiterplättchen aus Silicium wird wie im Beispiel 1 in eine Diffusionskapsel mit einer Diffusionsquelle aus Arsen gebracht und erhitzt. Anschließend wird das Halbleiterplättchen in eine offene Diffusionskammer gebracht, durch die eine Mischung aus $BBr_3$, Sauerstoff und Argon bei einer Temperatur von 1050°C geleitet wird. Der Gasfluß wird nach 10 Minuten unterbrochen und durch einen Gasfluß aus Sauerstoff ersetzt. Sauerstoff wird bei einer Temperatur von 1000°C während einer Dauer von 100 Minuten zugeführt. Beim letzten Verfahrensschritt handelt es sich um den Eintreibprozeß. Bei der Untersuchung des Halbleiterplättchens lassen sich sehr hohe Dichten von Kristallfehlern feststellen. Die maximale Borkonzentration wurde bei einem nicht mit Arsen dotierten Hilfshalbleiterplättchen ermittelt und ergab sich zu $2 \times 10^{20}$ Atome/cm³. Dieses Beispiel zeigt, daß in den Überlappungsbereichen Kristallfehler entstehen, wenn die Borkonzentration die angegebenen Grenzwerte überschreitet.

**Patentansprüche**

1. Verfahren zur Herstellung von hochintegrierten Halbleiteranordnungen mit aneinandergrenzenden, hochdotierten Halbleiterzonen (32, 34) entgegengesetzten Leitungstyps, wobei in Überlappungsbereichen der beiden Halbleiterzonen Kristallfehler vermieden werden, dadurch gekennzeichnet, daß in ein Halbleitersubstrat (30) aus Silicium eine erste, arsendotierte Halbleiterzone (32) mit einen Maximum der Arsenkonzentration im Bereich von $5 \times 10^{20}$ bis $2 \times 10^{21}$ Atome/cm³ und eine zweite, die erste mindestens teilweise überlappende, bordotierte Halbleiterzone (34) mit einem Maximum der Borkonzentration im Bereich von $5 \times 10^{19}$ bis $3 \times 10^{20}$ Atome/cm³ eingebracht wird.

2. Verfahren nach Anspruch 1, dadurch gekennzeichnet, daß zur Herstellung der zweiten Halbleiterzone auf das Halbleitersubstrat einen ein entsprechendes Maskenfenster aufweisende Maskierungsschicht aufgebracht wird, daß das Substrat in eine Bor als Diffusionsquellenmaterial enthaltende Diffusionskapsel gebracht wird, die abgeschlossen wird, daß das Quellenmaterial durch Erhitzung der Diffusionskapsel verdampft wird und daß die Erhitzung so lange fortgesetzt wird, bis die angestrebten Werte der Diffusionstiefe und des Schichtwiderstandes erreicht sind.

3. Verfahren nach Anspruch 2, dadurch gekennzeichnet, daß die Erhitzung mit einer Temperatur in der Größenordnung von 1050°C bei einer Dauer im Bereich von 2 bis 3 Stunden erfolgt.

4. Verfahren nach Anspruch 1, dadurch gekennzeichnet, daß zur Herstellung der zweiten Halbleiterzone auf das Halbleitersubstrat eine ein entsprechendes Maskenfenster aufweisende Maskierungsschicht aufgebracht wird, daß das Halbleitersubstrat auf eine Temperatur im Bereich von 925 bis 970°C erhitzt wird, daß über das Halbleitersubstrat eine eine glasartige Schicht bildende gasförmige Mischung aus $BBr_3$, $O_2$ und einem inerten Gas geleitet wird, daß die glasartige Schicht entfernt wird und daß das Halbleitersubstrat auf eine Temperatur im Bereich von 1000 bis 1050°C erhitzt wird.

5. Verfahren nach einem der Ansprüche 1 bis 4, dadurch gekennzeichnet, daß zur Herstellung der ersten Halbleiterzone auf das Halbleitersubstrat einen ein entsprechendes Maskenfenster aufweisende Maskierungsschicht aufgebracht wird, daß das Halbleitersubstrat in eine Arsen als Diffusionsquellenmaterial enthaltende Diffusionskapsel gebracht wird, die abgeschlossen wird, daß das Quellenmaterial durch Erhitzung der Diffusionskapsel verdampft wird und daß die Erhitzung so lange fortgesetzt wird, bis die angestrebte Diffusionstiefe erreicht ist.

6. Verfahren nach Anspruch 1, dadurch gekennzeichnet, daß die erste und/oder die zweite Halbleiterzone durch Ionenimplantation hergestellt wird.

**Claims**

1. Methods of making highly integrated semiconductor arrangements with adjacent, highly doped semiconductor regions (32, 34) of the opposite conductivity type, crystallographic faults being avoided in overlapping zones of these two semiconductor regions, characterized in that into a semiconductor substrate (30) of silicon a first arsenic doped semiconductor region (32) with a maximum of arsenic concentration between $5 \times 10^{20}$ to $2 \times 10^{21}$ atoms/cm$^3$, and a second boron doped semiconductor region (34) is introduced which at least partly overlaps with the first one and has a maximum of boron concentration between $5 \times 10^{19}$ to $3 \times 10^{20}$ atoms/cm$^3$.

2. Method as claimed in claim 1, characterized in that for making the second semiconductor region, a masking layer having a corresponding masking window is applied on the semiconductor substrate, that the substrate is placed in a diffusion capsule containing boron as diffusion source material, which is sealed, that the source material is vaporized by heating the diffusion capsule, and that heating is continued until the desired values of diffusion depths and sheet resistivity have been reached.

3. Method as claimed in claim 2, characterized in that heating is effected at a temperature in the order of 1050°C for a time between 2 to 3 hours.

4. Method as claimed in claim 1, characterized in that for making the second semiconductor region a masking layer with a corresponding masking window is applied on the semiconductor substrate, that the semiconductor substrate is heated to a temperature in the range from 925 to 970°C, that a gaseous mixture of $BBr_3$, $O_2$ and an inert gas which forms a glassy layer is directed over the semiconductor substrate, that the glassy layer is removed, and that the semiconductor substrate is heated to a temperature in the range of 1000 to 1050°C.

5. Method as claimed in any one of claims 1 to 4, characterized in that for making the first semiconductor zone a masking layer with a corresponding masking window is applied on the semiconductor substrate, that the semiconductor substrate is placed in a diffusion capsule containing arsenic as a diffusion source material, which is then sealed, that the source material is vaporized through heating the diffusion capsule, and that heating is continued until the desired diffusion depth has been reached.

6. Method as claimed in claim 1, characterized in that the first and/or the second semiconductor region is made by ion implantation.

**Revendications**

1. Procédé pour fabriquer des dispositifs semi-conducteurs à haute densité d'intégration comportant des régions semi-conductrices adjacentes (32, 34) fortement dopées du type de conductivité opposé, dans lequel on évite la formation de défauts cristallins dans les régions de chevauchement des deux régions semi-conductrices, caractérisé en ce qu'on forme, dans un substrat semi-conducteur (30) de silicium, une première région semi-conductrice (32) dopée avec de l'arsenic dont la concentration maximum en arsenic est comprise entre $5 \times 10^{20}$ et $2 \times 10^{21}$ atomes/cm$^3$, et une seconde région semi-conductrice (34) dopée avec du bore chevauchant la première région au moins partiellement et dont la concentration maximum en bore est comprise entre $5 \times 10^{19}$ à $3 \times 10^{20}$ atomes/cm$^3$.

2. Procédé selon la revendication 1, caractérisé en ce qu'on dispose sur le substrat semi-conducteur une couche de masquage comportant une ouverture de masque correspondante pour réaliser la seconde région semi-conductrice, en ce qu'on place le substrat dans une chambre de diffusion contenant du bore comme source de diffusion, cette chambre étant fermée, en ce que le matériau de source s'évapore en chauffant la chambre de diffusion, et en ce que le chauffage de celle-ci est continué jusqu'à obtention des valeurs désirées concernant la profondeur de diffusion et la résistance de couche.

3. Procédé selon la revendication 2, caractérisé en ce que le chauffage a lieu à une température de l'ordre de grandeur de 1050°C pendant une durée comprise entre 2 et 3 heures.

4. Procédé selon la revendication 1, caractérisé en ce qu'on dispose sur le substrat semi-conducteur une couche de masquage comportant une ouverture de masque correspondante pour réaliser la seconde région semi-conductrice, en ce qu'on chauffe le substrat semi-conducteur à une température comprise entre 925 et 970°C, en ce qu'on fait passer sur le substrat semi-conducteur un mélange gazeux de $BBr_3$, $O_2$ et d'un gaz inerte, formant une couche vitreuse; et en ce qu'on enlève la chouce vitreuse et on chauffe le substrat semi-conducteur à une température comprise entre 1000 et 1050°C.

5. Procédé selon l'une quelconque des revendications 1 à 4, caractérisé en ce qu'on dispose sur le substrat semi-conducteur une couche de masquage comportant une ouverture de masque correspondante pour réaliser la première région semi-conductrice; en ce qu'on place le substrat semi-conducteur dans une chambre de diffusion contenant de l'arsenic comme source de diffusion, la chambre étant fermée, en ce qu'on évapore le matériau de source en chauffant la chambre de diffusion; et en ce qu'on continue le chauffage jusqu'à ce que le profondeur de diffusion désirée soit atteinte.

6. Procédé selon la revendication 1, caractérisé en ce qu'on réalise la première et/ou la seconde région semi-conductrice par implantation ionique.

FIG.1

FIG.2

FIG.3A

FIG.3B

FIG.3C

FIG.3D

FIG.3E

1